Europäisches Patentamt

European Patent Office

Office européen des brevets

(19)

(11) Numéro de publication : **0 478 399 A1**

# (12) DEMANDE DE BREVET EUROPEEN

(21) Numéro de dépôt : **91402196.9**

(22) Date de dépôt : **06.08.91**

(51) Int. Cl.⁵ : **H01L 39/22**

(30) Priorité : **21.08.90 FR 9010513**

(43) Date de publication de la demande :
**01.04.92 Bulletin 92/14**

(84) Etats contractants désignés :
**DE FR GB NL**

(71) Demandeur : **THOMSON-CSF**
**51, Esplanade du Général de Gaulle**
**F-92800 Puteaux (FR)**

(72) Inventeur : **Tyc, Stephane**
**THOMSON-CSF SCPI Cédex 67**
**F-92045 Paris la Défense (FR)**
Inventeur : **Schuhl, Alain**
**THOMSON-CSF SCPI Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Transistor à effet de champ à supraconducteur.**

(57) Transistor à effet de champ comportant, sur un substrat (1), une couche (2) de matériau semiconducteur incorporant des inclusions (20, 21) naturelles ou artificielles en matériau supraconducteur. Sur cette couche (2) sont réalisées les électrodes de source, de drain et de grille (3, 4, 5).
APPLICATIONS : Transistors à effet de champ à tension de commande de grille faible

FIG.3

EP 0 478 399 A1

L'invention concerne un transistor à effet de champ utilisant la supraconductivité et plus particulièrement un transistor à effet de champ dont le canal est alternativement rendu supraconducteur ou résistif par l'application d'un champ électrique sur la grille.

Les composants basés sur un effet supraconducteur ont deux champs d'application principaux : la détection ultra sensible (en particulier dans l'infra rouge) et la logique avec très peu de dissipation et de très grandes vitesses de commutation. Toutefois des applications en logique ne semblent pouvoir faire simplement sans l'utilisation de composants à trois terminaux (en effet la logique à base de jonctions Josephson est difficile).

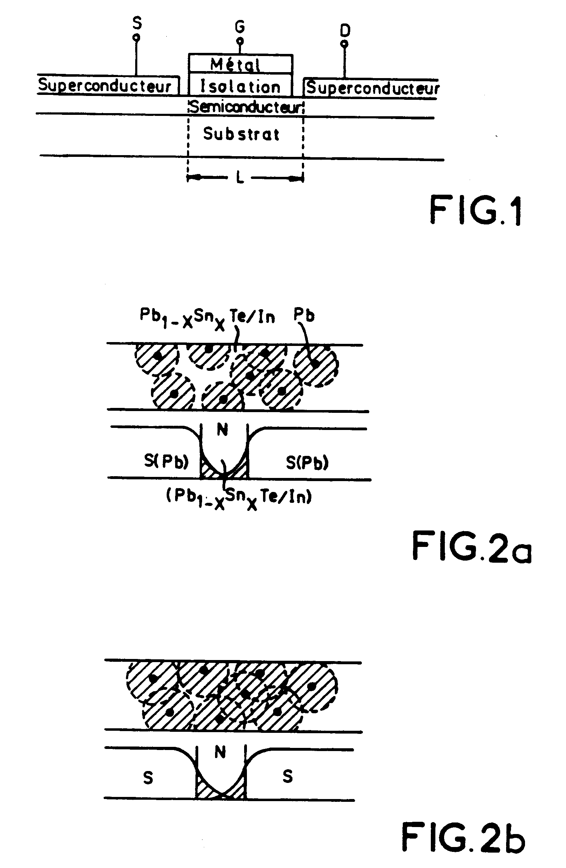

De nombreux composants à trois terminaux ont été proposés à ce jour, en particulier un transistor Josephson à effet de champ (JOFET), tel que décrit dans le document de A. W. KLEINSASSER et al. publié dans SUPERCONDUCTING DEVICES Edited by S. Ruggiera and D. Rudman Academic Press, Inc, San Diego (1990). Le principe de fonctionnement est identique à celui du FET à ceci près que les électrodes sont en matériau supraconducteur et que le canal semiconducteur supporte un courant supraconducteur qui est lui-même modulé par la tension de grille (voir figure 1). Le courant supraconducteur peut se propager dans le semiconducteur grâce à l'effet de proximité bien connu entre les métaux normaux et les supraconducteurs et aussi démontré entre les semiconducteurs et les supraconducteurs.

Toutefois il n'a pas encore été réalisé de composant de la famille JOFET dont les caractéristiques soient suffisamment bonnes pour être utiles.

D'autre part la supraconductivité d'une couche (canal) peut être commandée en modulant la densité électronique dans certains systèmes particuliers. Dans les sels de plomb qui sont des semiconducteurs à petite bande interdite, petite masse effective et grande mobilité, il est possible de préparer des couches semiconductrices qui présentent des inclusions de gouttes de plomb métallique comme cela est décrit dans le document " CONTROLLABILITY OF SUPERCONDUCTING BEHAVIOR BY PHOTO-ILLUMINATIONS IN INDIUM DOPED $Pb_{1-x}Sn_xTe$ WITH LEAD INCLUSION" de S. TAKAOKA et al. 20th conference of Semiconductors - Thessalonik-GREECE-August 6, 1990. A basse température ces inclusions deviennent supraconductrices et l'existence d'un courant supraconducteur reliant ces inclusions est fonction de la densité électronique dans la matrice semiconductrice. Cet effet a été démontré par le document Takaoka et al. En faisant varier la densité électronique dans la matrice semiconductrice par photoexcitation d'électrons (illumination), des améliorations de la température critique du système ont été obtenues.

La figure 2a représente, selon le document TAKAOWA des inclusions de plomb dans un matériau de $Pb_{1-x}Sn_xTe/In$ et met en évidence (zones hachurées) la pénétration de l'état supraconducteur dans le matériau semiconducteur ($Pb_{1-x}Sn_xTe/In$).

La figure 2b met en évidence que ce dispositif exposé à la lumière voit ses régions supraconductrices s'étendre et sa supraconductivité augmente.

Les inconvénients de l'approche des JOFETs sont doubles. D'une part, pour obtenir des courants supraconducteurs non négligeables par rapport au courant normal il faut des longueurs de canal extrèmement faibles et donc difficiles à fabriquer. D'autre part, les tensions entre source et drain auxquelles les effets supraconducteurs sont importants sont intrinsèquement limitées par l'énergie de condensation des paires de Cooper (environ 1mV dans les anciens supraconducteurs et 10 mV dans les nouveaux) alors que les tensions de grille requises pour moduler la conduction dans le canal sont au minimum de l'ordre de centaines de mV.

Le système du document Takaoka et al. a l'inconvénient d'avoir des temps de réponse très longs ; les électrons photoexcités se recombinent lentement.

L'invention concerne donc un transistor à effet de champ qui remédie à ces inconvénients.

L'invention concerne donc un transistor à effet de champ caractérisé en ce qu'il comporte, sur un substrat, une couche d'un matériau semiconducteur contenant des inclusions en matériau supraconducteur (naturelles ou artificielles comme dans les boîtes quantiques), et disposées à la surface de la couche de matériau semiconducteur, une électrode de grille disposée entre une électrode de drain et une électrode de source, l'électrode de grille étant commmandée par une tension de grille.

De plus, selon l'invention les électrodes de grille, de drain et de source comportent soit des contacts ohmiques en matériau conducteur normal soit des connexions en matériaux supraconducteur.

Les différents objets et caractéristiques de l'invention apparaîtront plus clairement dans la description qui va suivre faite à titre d'exemple et dans les figures annexées qui représentent :

– les figures 1, 2a et 2b des dispositifs connus dans la technique décrits précédemment ;
– la figure 3, un exemple de réalisation du dispositif selon l'invention ;
– la figure 4, une variante de réalisation du dispositif de l'invention.

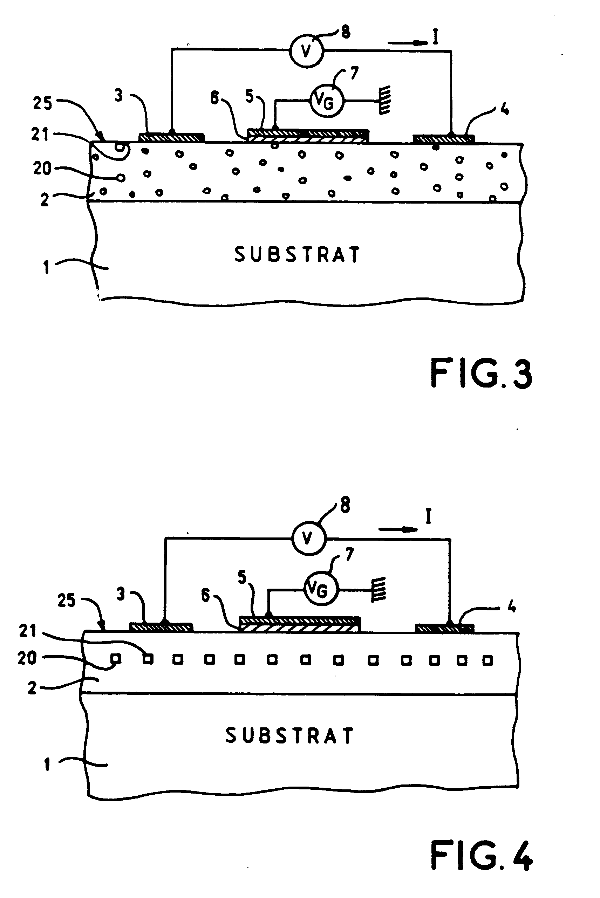

L'exemple de réalisation du dispositif de l'invention de la figure 3 comporte, sur un substrat 1, une couche 2 en matériau semiconducteur comprenant des inclusions de matériau supraconducteur, telles que 20 et 21, réparties dans l'épaisseur de la couche 2.

A la surface 25 de la couche 2 sont localisées une électrode de drain 3 et une électrode source 4 connectées à une source de polarisation 8.

Entre ces deux électrodes, se trouve une électrode de grille 5 à laquelle est connectée une source de tension de grille de commande 7.

Les électrodes de drain et de source 3 et 4 sont réalisées à l'aide de contacts ohmiques. Ces contacts ohmiques sont en matériau conducteur normal ou supraconducteur.

L'électrode de grille 5 peut être réalisée sous forme d'un contact Sclottky. Elle peut également comporter, comme cela est représenté en figure 3, une couche d'un matériau isolant 6 située entre une couche de contact 5 et la couche 2. L'électrode 5 peut également être une jonction pn ou tout autre dispositif connu permettant de moduler la densité électronique dans la couche 2.

De cette manière le supracourant entre drain et la source est commandé par la tension appliquée sur la grille. Cette tension module la densité électronique dans le canal et permet ou non au supracourant de se propager d'une électrode à l'autre par percolation à travers les inclusions supraconductrices.

Dans la figure 3, le mode de réalisation est tel que la répartition des inclusions n'est pas complètement contrôlée. Les inclusions sont réalisées naturellement lors de la réalisation de la couche 2.

La figure 4 représente un mode de réalisation dans lequel les inclusions sont faites sous la forme de boîtes quantiques dont on peut contrôler la position selon les techniques de réalisation des boîtes quantiques.

L'invention permet ainsi de résoudre le problème de la proximité des électrodes surpaconductrices en ayant des distances entre les inclusions supraconductrices faibles. Ceci permet d'abaisser la densité électronique nécessaire dans la matrice semiconductrice pour établir un courant supraconducteur et par là même d'abaisser la tension de commande de la grille.

L'invention permet également de mettre en série des systèmes équivalents à de petits JOFET élémentaires entre les inclusions supraconductrices et conduit à des tensions drain- source supérieures à l'énergie de condensation des paires de Cooper.

Selon un exemple de réalisation pratique du dispositif de l'invention, la couche 2 est un sel de plomb tel que :

$$Pb_{1-x} Sn_x Te$$

ou

$$Pb_{1-x} Sn_x Se$$

avec x compris sensiblement entre 0 et 0,5.

Par exemple x peut avoir pour valeur 0, 25.

Les inclusions de matériau supraconducteur (20, 21) sont alors des inclusions de plomb qui se forme lors de la réalisation de la couche 2. Le pourcentage d'inclusions de plomb est par exemple de 1 %.

Dans cet exemple de réalisation, la couche 2 a sensiblement pour épaisseur 100nm ou est inférieure à 100nm.

Les électrodes de source et de drain 3 et 4 sont des contacts ohmiques en or.

Si la grille comporte une couche d'isolant 6, le contact ohmique 5 peut être en or.

Selon une variante de réalisation de l'invention, la couche 2 en matériau semiconducteur est en PbS et que les inclusions sont à base de plomb.

Selon une autre variante, la couche 2 est en InAs ou InGaAs. Les inclusions de matériau supraconducteur peuvent alors être de l'indium (In) ou du gallium (Ga).

Selon encore une autre variante de réalisation, la couche 2 peut également être en GaAs faible température (en terminologie anglo-saxonne : "Low-Temperature-Grown GaAs "). Dans un tel matériau, il existe une partie du matériau qui peut être supraconducteur comme cela est décrit dans l'article de J.M. BARANOWSKI et al, "Evidence for Superconductivy in Low-Temperature-Grown GaAs", Physical Review Letters, volume 66, N° 23, June 10, 1991.

Il est bien évident que la description qui précède n'a été faite qu'à titre d'exemple non limitatif, et d'autres variantes peuvent être envisagées. Les exemples numériques et de matériaux n'ont été fournis que pour illustrer la description.

## Revendications

1. Transistor à effet de champ caractérisé en ce qu'il comporte, sur un substrat (1), une couche d'un matériau semiconducteur (2) contenant des inclusions en matériau supraconducteur (20, 21), et disposées à la surface de la couche de matériau semiconducteur (2), une électrode de grille (5) disposée entre une électrode de drain (3) et une électrode de source (4), l'électrode de grille étant commandée par une tension de grille ($V_G$).

2. Transistor à effet de champ selon la revendication 1, caractérisé en ce que les inclusions (20, 21) sont réparties régulièrement dans la couche de matériau semiconducteur (20).

3. Transistor à effet de champ selon la revendication 1, caractérisé en ce que les électrodes de grille, de drain et de source (3, 4, 5) comportent des contacts ohmiques en matériau conducteur normal.

4. Transistor à effet de champ selon la revendication 1, caractérisé en ce que les électrodes de grilles, de drain et de source (3, 4, 5) comportent des contacts en matériau supraconducteur.

5. Transistor à effet de champ selon l'une des revendications 3 ou 4, caractérisé en ce que l'électrode de grille comporte, entre le contact (5) et la couche de matériau semiconducteur (2), une couche de matériau isolant (6).

6. Transistor à effet de champ selon la revendication 1, caractérisé en ce que l'électrode de grille comporte un contact SCHOTTKY ou une jonction PN.

7. Transistor à effet de champ selon l'une des revendications 3 ou 4, caractérisé en ce que le matériau semiconducteur (2) est un sel de plomb et que les inclusions de matériau supraconducteur (20, 21) sont à base de plomb.

8. Transistor à effet de champ selon la revendication 4, caractérisé en ce que le sel de plomb a pour formule :

$$Pb_{1-x} Sn_x \ Te \ ou \ Pb_{1-x} Sn_x \ Se$$

avec sensiblement $0 < x < 0,5$

9. Transistor à effet de champ selon la revendication 7, caractérisé en ce que le sel de plomb est du PbS.

10. Transistor à effet de champ selon l'une des revendications 3 ou 4, caractérisé en ce que le matériau semiconducteur (2) est en InAs ou en GaInAs et que les inclusions de matériau supraconducteur (20, 21) sont à base d'indium.

11. Transistor à effet de champ selon l'un des revendications 3 ou 4, caractérisé en ce que le matériau semiconducteur (2) est en InAs ou en GaInAs et que les inclusions de matériau supraconducteur (20, 21) sont à base de gallium.

12. Transistor à effet de champ selon la revendication 1, caractérisé en ce que la couche de matériau semiconducteur (2) contenant des inclusions en matériau supraconducteur (20, 21) est en GaAs basse température.

S      G      D

| | Métal | |
| Superconducteur | Isolation | Superconducteur |

Semiconducteur

Substrat

← L →

## FIG.1

$Pb_{1-X}Sn_X Te/In$     Pb

N

S(Pb)           S(Pb)

$(Pb_{1-X}Sn_X Te/In)$

## FIG.2a

N

S          S

## FIG.2b

FIG.3

FIG.4

EP 0 478 399 A1

Office européen
des brevets

**RAPPORT DE RECHERCHE EUROPEENNE**

Numero de la demande

EP 91 40 2196

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN vol. 14, no. 28 (E-875)(3971), 19 janvier 1990; & JP - A - 265576 (SHARP) 23.10.1989 * abrégé; figure * | 1-8 | H 01 L 39/22 |
| A | PATENT ABSTRACTS OF JAPAN vol. 12, no. 44 (E-581)(2891), 9 février 1988; & JP - A - 62195189 (NTT) 27.08.1987 * abrégé; figure * | 8-12 | |
| A | SOLID STATE COMMUNICATIONS vol. 76, no. 1, juillet 1990, pages 31-34, GB; T. KOSHINDO et al.: "Enhancement of superconducting transition temperature by photo-carriers in indium doped Pb1-xSnxTe film with lead inclusion" * figure 1; page 31; abrégé * | 7,8 | |
| A | EP-A-0 185 104 (IBM) * abrégé; figures 2A,2B; revendication 7 * | 12 | |
| A | EP-A-0 093 557 (TOSHIBA) * abrégé; figure 1; page 8 * | 1 | **DOMAINES TECHNIQUES RECHERCHES (Int. Cl.5)** H 01 L |
| D,P A | PHYSICAL REVIEW LETTERS vol. 66, no. 23, 10 juin 1991, pages 3079-3082, New York, US; J.M. BARANOWSKI et al.: "Evidence for Superconductivity in Low-Temperature-Grown GaAs" * page 3082, colonne 1, paragraph 3; abrégé * | 10,12 | |

Le présent rapport a été établi pour toutes les revendications

| Lieu de la recherche | Date d'achèvement de la recherche | Examinateur |
|---|---|---|
| BERLIN | 03-12-1991 | JUHL A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)

7